# EUROPÄISCHE PATENTSCHRIFT

(11) **EP 1 284 302 B1**
(45) Veröffentlichungstag und Bekanntmachung des Hinweises auf die Patenterteilung: **11.10.2006**
(21) Anmeldenummer: 02018329.9
(22) Anmeldetag: 14.08.2002
(51) Int. Cl.: C23C 14/34

(54) **Sputtertarget auf Basis von Titandioxid**
Titanium dioxide based sputtering target
Cible de pulvérisation à base de dioxyde de titane

(30) Priorität: 17.08.2001 DE 10140514
(43) Veröffentlichungstag der Anmeldung: 19.02.2003
(73) Patentinhaber: W.C. Heraeus GmbH, 63450 Hanau (DE)
(72) Erfinder: Schultheis, Markus, 36043 Fulda (DE); Simons, Christoph, Dr., 63599 Biebergemünd (DE); Weigert, Martin, Dr., 63457 Hanau (DE)
(74) Vertreter: Kühn, Hans-Christian

(56) Entgegenhaltungen:
- EP-A- 1 068 899
- US-B1- 6 193 856
- PATENT ABSTRACTS OF JAPAN vol. 1996, no. 01, 31. Januar 1996 (1996-01-31) & JP 07 233469 A (ASAHI GLASS CO LTD), 5. September 1995 (1995-09-05)

## Beschreibung

Die Erfindung betrifft ein Sputtertarget aus Titandioxid, das zur Herstellung optisch aktiver Funktionsschichten aus Titandioxid verwendet wird. Solche Schichten werden z. B. in Kombination mit Schichten aus anderen Materialien in der großflächigen Glasbeschichtung zur Herstellung von Architekturglas eingesetzt.

Wärmestrahlenreflektierende Schichtsysteme aus z. B. einer Silberschicht als Funktionsschicht und mindestens einer weiteren Schicht aus einem Metalloxid als dielektrische Entspiegelungsschicht sind z. B. aus der DE 41 35 701 A1 bekannt. Die über der Silberschicht angeordnete Metalloxidschicht hat zusätzlich z. B. die Aufgabe, eine Langzeitschädigung der Silberschicht durch Oxidation zu vermeiden. Eine Forderung an die Metalloxidschicht ist, dass die Transmission des gesamten Schichtsystems im sichtbaren Wellenlängenbereich des Lichtes nicht zu stark reduziert werden darf (z. B. ist bei Windschutzscheiben für Kraftfahrzeuge ein Transmissionsgrad von mindestens 75 % erforderlich DE 198 58 227 C1).

Die Grundforderung an solche Schichtsysteme ist damit eine möglichst hohe Transmission im Spektralbereich der Sonnenstrahlung, d. h. bei einer Wellenlänge zwischen 300 und 2500 nm, und insbesondere im Bereich des sichtbaren Lichtes zwischen 380 und 780 nm, während im Bereich der Wärmestrahlung, d. h. im Wellenlängenbereich von 4000 bis 50000 nm ein möglichst niedriger Wert der Emissivität gefordert wird (DE 199 22 162 A1). Solche Schichtsysteme werden in der Literatur auch als "low-e coating" (low heat emissivity) beschrieben, z. B. (Szczyrbowski et.al. 1999 Society of Vacuum Coaters 505/856-7188, 42^{nd} Annual Technical Conference Proceedings (1999), S. 141-146). In praxi werden dazu über und/oder unter die Silberschichten dielektrische Schichten als sogenannte "Grundschichten" bzw. "Deckschichten" aufgebracht. Dabei sind unterschiedliche Metalloxide und auch Mehrfachkombinationen anwendbar.

Die Anforderungen an die Homogenität und Langzeitstabilität der so hergestellten Schichten wird bei der zunehmenden Verwendung von immer größeren Substraten (z. B. sind Glastafeln mit einer Abmessung von 3,21 m mal 6,00 m üblich, DE 199 22 162 A1) höher und auch die verfahrenstechnischen Prozessparameter müssen stabil beherrscht werden.

Beispielsweise soll hier nur kurz darauf hingewiesen werden, dass bei vielen der für die beschriebenen Anwendungen geeigneten Metalloxidschichten, die eine solche geforderte hochbrechende Eigenschaft aufweisen, die Metalloxide in mehreren Modifikationen auftreten können. Bei der Herstellung der Schichtsysteme muss aber die Forderung nach der Reproduzierbarkeit des Brechungsindexes der hochbrechenden Schicht unbedingt erfüllt werden, im speziellen Anwendungsfall steht die Forderung, einen Brechungsindex von über 2,3 zu garantieren, da sonst die gewünschte optische Funktion der Titandioxidschicht nicht erfüllt wird. Am Beispiel Titandioxid, das in rutiler, anastaser und brookiter Modifikation auftreten kann, die alle unterschiedliche mechanische und optische Eigenschaften besitzen, bedeutet dies, dass je nach Kristallgitterstruktur, d. h. je nach Modifikation des Titandioxides der Brechungsindex zwischen 1,9 bis zu 2,6 variieren kann. Geringe Instabilitäten in der Prozessführung können somit einen signifikanten Einfluss auf den Brechungsindex der Schicht ausüben.

Zur Herstellung der Titandioxidschichten auf unterschiedlichen Substraten sind in der Literatur eine große Zahl von unterschiedlichen Verfahren wie z. B. Sputtern, Verdampfen, chemical vapor deposition und metal-organic decomposition beschrieben. In der DE 198 45 291 A1 wird z. B. ein nasschemisches Verfahren über einen Sol-Gel-Prozess beschrieben, bei dem zunächst ein lösliches titanhaltiges Pulver hergestellt wird, das nach einem chemischen Prozess auf ein Substrat aufgebracht wird und nach einem anschließenden Temperprozess die Schicht erzeugt.

Im Unterschied zu diesem vorgenannten Verfahren werden bei den PVD-Verfahren (physical vapor deposition) die Schichten auf der Oberfläche eines Substrates so erzeugt, dass das Beschichtungsmaterial in die Gasphase gebracht wird, wobei üblicherweise mit einem Metall oder einer Metallverbindung die Schicht erzeugt wird. Der Vorteil dieser PVD-Verfahren liegt in der Tatsache, dass sich fast alle Metalle, ihre Legierungen und metallischen Verbindungen auf so gut wie allen Materialien (dem Substrat) abscheiden lassen, d. h. geeignet als Substrat sind z. B. Glas, Kunststoff, Keramik, Metalle, Metalllegierungen.

Zu den PVD-Verfahren zählt das Sputtern oder Kathodenzerstäuben, wobei das Sputtergas (z. B. Argon) in einem Plasma ionisiert wird und in einer Gasatmosphäre die so entstandenen Edelgasionen auf eine Materialquelle (das Target) gelenkt werden. Die Energie der Ionen ist dabei so groß, dass aus dem Target Atome als Beschichtungsmaterial herausschlagen werden. Die zerstäubten Bestandteile des Targets bilden auf der Oberfläche des zu beschichtenden Werkstückes die gewünschte Schicht, wobei durch die Prozessparameter während des Sputtervorganges die Schichteigenschaften wie Härte, Gefügestruktur, Haftfestigkeit, elektrische Leitfähigkeit, optische Eigenschaften und die chemische sowie thermische Stabilität gezielt beeinflusst werden können.

Elektrisch leitfähige Materialien können mit einer Gleichstromquelle gesputtert werden, während beim Sputtern dielektrischer Materialien z. B. ein Hochfrequenz-Plasma vor dem Target gezündet werden muss, damit die Spannung nicht schon über dem isolierenden Targetmaterial abfällt.

Das Sputtern, d. h. Kathodenzerstäuben, hat gegenüber dem "klassischen" Verdampfen den Vorteil, dass wesentlich mehr Kombinationen bei der Auswahl des Materials hinsichtlich des zu beschichtenden und des zu "verdampfenden" Werkstoffes bestehen. So ist ein nicht unerhebliche Vorteil, dass z. B. die Möglichkeit der Einbeziehung von Reaktionen im sogenannten "Dampfraum" mit dem Plasma einbezogen werden kann in den gesamten Verfahrensprozess, d. h. man arbeitet mit "reaktivem Sputtern", womit dann weitere Variationsmöglichkeiten erschlossen werden können.

Entsprechend den gewünschten Prozessparametern bei den Gasentladungskenngrößen werden vorwiegend inerte Gase, insbesondere Argon oder Helium verwendet. Darüber hinaus können auch reaktive Gase, wie z. B. Sauerstoff, Azetylen oder Stickstoff, zum Reaktivgassputtern eingesetzt werden. Sowohl beim Inertgassputtern als auch beim Reaktivgassputtern stellt das Sputtertarget das zu verbrauchende Materialreservoir dar, aus dem die zu bildende Schicht bei Inertgassputtern ausschließlich und beim Reaktivgassputtern in Form eines Reaktionsproduktes mit dem Reaktionsgas auf dem Substrat abzuscheiden ist. Damit sind die prinzipiellen Möglichkeiten als Stand der Technik beschrieben, mit denen dünne Schichten aus dielektrischen Werkstoffen (d. h. im Fall der vorliegenden Erfindung Metalloxide, wie Titandioxid) durch Sputtern erzeugt werden können, entweder es wird ein Target aus Titan verwendet, dessen Metallkomponente im Plasma mit Sauerstoff reagiert und eine so entstandene Titandioxidschicht wird auf dem Substrat abgeschieden oder man verwendet direkt ein Target aus Titandioxid, das zerstäubt und als Schicht auf dem Substrat abgeschieden wird.

In der DE 42 11 363 A1 und DE 195 20 843 A1 werden z. B. solche Verfahren zur Herstellung von Schichten mit einem hohen Transmissionsverhalten im sichtbaren Spektralbereich und mit einem hohen Reflexionsverhalten für Wärmestrahlen unter Anwendung des Reaktivsputterns und die so hergestellten Schichtkombinationen mit einer in das Schichtsystem integrierten Schicht aus Titandioxid beschrieben. Bei den bekannten reaktiven Sputterverfahren stellt das Target die Kathode dar. Alternativ werden auch sogenannte Doppelelektroden verwendet, die wechselweise alternierend als Anode und Kathode geschaltet werden. Die elektrische Leistung wird entweder als Gleichstrom oder als Wechselstrom den Elektroden zugeführt, wie z.B. in der DE 38 02 852 A1 beschrieben.

Zur Abscheidung dielektrischer Schichten, z.B. SiO₂, Al₂O₃, ZrO₂, TiO₂, ZnO, besteht das zu zerstäubende Target dann aus der entsprechenden, in den vorgenannten Verbindungen als Element vorliegenden Metallkomponente, auf die eine z.B. aus einem ionisierten Ar/O₂- oder Ar/N₂-Gemisch bestehende Plasmawolke trifft und die so auf das Metalltarget zerstäubend einwirkt. Auf dem Substrat werden dann auf seiner Oberfläche die gebildeten Oxidverbindungen (oder wahlweise auch Nitridverbindungen) abgeschieden.

Aus der DE 196 44 752 A1 ist bekannt, dass stabile Sputterbedingungen zur Erzielung hochwertiger Metalloxidschichten mit hoher optischer Güte in reproduzierbarer und industriell kostengünstiger Weise nur mit Hilfe aufwändiger Prozesskontrollvorrichtungen einstellbar sind. Das Problem bei der stabilen Herstellung solcher dielektrischer Titandioxidschichten im reaktiven Sputtermodus nach dem in o. g. Patenschrift angewendeten DC-Sputtern liegt darin begründet, dass die Kathodenkennlinie der mit Gleichspannung versorgten Hochleistungskathode, in der das Titantarget integriert ist, eine Hystereseschleife aufweist. Dadurch kann der Sputterarbeitspunkt, je nach Sauerstoffzuführung in den Plasma-Reaktionsraum, vom metallischen unkontrolliert in den oxidischen Sputterzustand überspringen.

Die Sputterrate selbst wird durch den Einsatz von mindestens zwei benachbarten jeweils zueinander im Plasmaraum angeordneten Elektroden erhöht, was besonders bei zu beschichtenden Substraten in Durchlaufanlagen wichtig ist. Weitere Einzelheiten zu den Sputterraten und Schichtwachstumsgeschwindigkeiten im Vergleich zu den herkömmlichen DC-Sputtern und der "TWIN-MAG"-Anwendung können der bereits zitierten Schrift entnommen werden (Szczyrbowski et.al. 1999 Society of Vacuum Coaters 505/856-7188, 42^{nd} Annual Technical Conference Proceedings (1999), S. 141-146).

Bekannt ist weiterhin, z. B. aus der US-Patentschrift 6 193 856 (WO 97/08359), dass die Geschwindigkeit des Schichtwachstums beim reaktiven Sputtern sehr gering ist, was sich besonders bei der großflächigen Beschichtung von Substraten ungünstig auswirkt, eine geringe Produktivität bewirkt und hohe Kosten verursacht. Eine bekannte Möglichkeit zur Vermeidung dieser Probleme wird in der o. g. Patentschrift US 6 193 856 angegeben, wobei der reaktive Teilprozess entfällt und direkt das dielektrische Metalloxid als Sputtertarget eingesetzt wird und auf dem Substrat dann z. B. ein Metalloxidfilm aus Titandioxid abgeschieden wird. Nachteilig ist bei diesem Verfahren, dass diese Metalloxide im allgemeinen keine oder eine nur äußerst geringe elektrische Leitfähigkeit ausweisen, daher also an sich für den Gleichspannungssputterprozess nicht geeignet sind.

Nach eigenen Ergebnissen beträgt der "kritische" Wert für den spezifischen elektrischen Widerstand eines Sputtertargets aus einem Metalloxid, vorzugsweise Titandioxid, das für einen Sputterprozess im Gleichspannungsverfahren geeignet ist, etwa 1 Ωcm, wobei eindeutig festzustellen ist, dass dies kein strenger mathematischer Wert ist, sondern hiermit nur eine Größenordung angegeben wird. Dieser "kritische" Wert hängt stark von den Anlagenparametern ab und wird auch in den Patentschriften unterschiedlich angegeben, z. B. wird in der WO 97/25450 der Betrag von 1 Ωcm bestätigt, jedoch auch eine vorzugsweise Größe von 0,1 Ωcm angegeben. In der WO 97/25451 werden 10 Ωcm als eindeutig zu hoch für einen Gleichspannungssputterprozess angegeben, empfohlen werden 0,5 Ωcm und der beste Wert wird mit 0,02 Ωcm angegeben.

Dabei wird in der Regel, z. B. nach der WO 97/25450 und der WO 97/25451, ein unterstöchiometrisches TiOₓ verwendet mit x im Bereich von 1,55 bis zu 1,95. Zur Erzeugung von Mehrfachschichtsystemen mit speziellen fotokatalytischen Eigenschaften ist aus der EP 1 068 899 A 1 bekannt, Oxide aus der Gruppe Niob, Tantal, Vanadium, Zirkon, Zinn, Zink, Chrom und Kupfer in einem Anteil von etwa 1 bis zu 10 Gew. % der Hauptkomponente Titandioxid zuzusetzen. Dabei werden die gewünschten aktiven Dünnschichten auf z. B. Glassubstraten erzeugt. Zur Herstellung der Schichten aus einer Mischung von Titandioxid und den genannten anderen Oxiden wird ein gesintertes Target aus dieser Mischung benutzt, das eine elektrische Leitfähigkeit besitzt.

Als Herstellungsverfahren für solche im Sauerstoffgehalt unterstöchiometrischen Sputtertargets aus Titandioxid für einen Sputterprozess im Gleichspannungsverfahren werden z. B. das Heißpressen in einer nichtoxidierenden Atmosphäre nach der JP -A-07-233469 oder ein reduzierendes Plasmaspritzverfahren nach der WO 97/08359 eingesetzt. Diese letztgenannten Verfahren sind aber sehr kostenintensiv.

Beim Einsatz der Titandioxidtargets zum Gleichspannungssputtern wird in der Patentliteratur, z. B. in der WO 97/25450, gegenüber dem herkömmlichen reaktiven Sputtern mit reinen Titantargets und einer Sauerstoffzuführung im Plasma, eine mögliche Verbesserung um den Faktor 10 für die Sputterrate angegeben.

Eine ökonomische Anwendung von solchen Titandioxidtargets scheitert dann aber im allgemeinen an den hohen Herstellungskosten.

Aufgabe der vorliegenden Erfindung ist es daher, ein Sputtertarget aus Titandioxid so herzustellen, dass es zum Gleichspannungssputtern geeignet ist, d. h. der spezifische elektrische Widerstand soll weniger als 5 Ωcm (vorzugsweise aber sogar weniger als 1 Ωcm) betragen. Dazu werden in geringen Mengen Dotierungskomponenten beigemischt, um die elektrische Leitfähigkeit der Sputtertargets zu erhöhen, wobei die Dotierungselemente aber andererseits keine negativen Einflüsse auf die Schichteigenschaften haben dürfen. Es muss garantiert sein, dass der Brechungsindex der auf dem Substrat abgeschiedenen Schicht größer als 2,3 ist und weiterhin darf durch die Dotierungskomponenten keine erhöhte Absorption bewirkt werden. Schließlich muss das Sputtertarget durch ein einfaches und verfahrenstechnisch leicht zu beherrschendes Verfahren, das auch besonders kostengünstig sein soll, in großen Stückzahl produziert werden können.

Erfindungsgemäß werden diese Aufgaben dadurch gelöst, dass dem Targetgrundmaterial aus Titandioxid Dotierungsstoffe beigemischt werden und diese Mischung durch eine einfache keramische Verfahrenstechnik, z. B. Kaltpressen und Sintern verarbeitet wird. Als Dotierstoff oder Dotierstoffgemisch werden Oxide aus der Gruppe Indiumoxid (In₂O₃), Zinkoxid (ZnO), Wismutoxid (Bi₂O₃), Galliumoxid (Ga₂O₃), Antimonoxid (Sb₂O₃) oder Zirkonoxid (ZrO₂) mit einem Anteil von kleiner als 5 mol-% beigemischt. Als besonders vorteilhaft hat es sich erwiesen, die Anteile in einem Bereich von 0,05 mol % bis zu 1,0 mol % zu beschränken. Besonders gute Ergebnisse werden erzielt, wenn Indiumoxid (In₂O₃) als Dotierungsmittel gewählt wird.

Die einzelnen Komponenten der Mischung aus Titandioxidpulver und dem Pulver aus dem gewählten Dotierungsmittel werden z. B. mit einem Taumelmischer oder in einem rotierenden Mischgefäß mit gegenläufigem Rührwerk vermischt, anschließend in eine Pressform gefüllt und verpresst. Der Pressdruck kann hierbei etwa 0,5 t/cm² bis zu 2,0 t/cm² betragen. Besonders vorteilhaft ist es zur Erzeugung homogen verdichteter Presskörper, wenn nach dem ersten Pressvorgang eine Nachverdichtung über einen isostatischen Pressprozess erfolgt, wobei der Pressdruck im zweiten Pressvorgang im Bereich von 2,0 t/cm² und 3,0 t/cm² liegt.

Nach dem Pressvorgang werden die Presslinge im Bereich von 1300 ° C bis zu 1600 ° C drucklos gesintert, die so erzeugten Dichten liegen im Bereich von 3,4 g/cm³ bis zu 4,1 g/cm³.

Mögliche Ausführungsbeispiele sind in der Tabelle aufgeführt.

**Tabelle der Ausführungsbeispiele mit Vergleichswerten**

| **Pulvermischung** | **Pressdruck** | **Sintertemperatur** | **Dichte** | **Spezifischer Elektrischer Widerstand** | **Quelle** |
|---|---|---|---|---|---|
| | [t/cm²] | [°C] | [g/cm³] | [Ωcm] | |
| 0,5 mol %ZrO₂, Rest TiO₂ | 0,7 | 1400 | 3,48 | 0,24 | Eigener Versuch |
| 1,0 mol %ZrO₂, Rest TiO₂ | 1,5 | 1450 | 3,80 | 0,15 | Eigener Versuch |
| 0,05 mol %In₂O₃, Rest TiO₂ | 1,5 | 1450 | 4,01 | 0,09 | Eigener Versuch |
| 0,25 mol % In₂O₃, Rest TiO₂ | 1,5 | 1450 | 3,90 | 0,04 | Eigener Versuch |
| 0,5 mol % In₂O₃, Rest TiO₂ | 1,5 | 1450 | 3,79 | 0,06 | Eigener Versuch |
| 0,5 mol % Al₂O₃, Rest TiO₂ * | 1,5 | 1450 | 3,85 | 0,21 | Eigener Versuch |
| 0,5 mol %Bi₂O₂, Rest TiO₂ | 1,8 | 1500 | 3,86 | 0,82 | Eigener Versuch |
| 0,05 mol % Al₂O₃ + 0,05 mol % In₂O₃ + 1,5 0,05 mol % ZrO₂, Rest TiO₂ | | 1500 | 3,92 | 0,19 | Eigener Versuch |
| 0,05 mol % ZnO + 0,05 mol % Al₂O₃, Rest TiO₂ | 1,5 | 1450 | 3,78 | 0,18 | Eigener Versuch |
| ---------------------------------- | ------------- | ------------------- | ---------- | -------------- | ------------------- |
| **Vergleichswerte** | | | | | |
| TiO₂ | 1,0 | 1400 | 3,85 | 1000 | Eigener Versuch |
| TiO₂ | | Heißgepresst bei 1100-1400 °C | 3,9-4,17 | 0,12-0,35 | Eigener Versuch |
| TiO₂ | | plasmagespritzt | | 0,02-0,5 | |

| | | | | | |
|---|---|---|---|---|---|
| * nicht gemäß der Erfindung | | | | | |

## Patentansprüche

1. Elektrisch leitfähiges Sputtertarget aus Titandioxid (TiO₂) mit einem spezifischen elektrischen Widerstand kleiner als 5 Ωcm, **dadurch gekennzeichnet, dass** dem Targetmaterial aus TiO₂ mindestens ein Dotierstoff oder ein Dotierstoffgemisch aus der Gruppe Indiumoxid (In₂O₃), Zinkoxid (ZnO), Wismutoxid (Bi₂O₃), Galliumoxid (Ga₂O₃), Antimonoxid (Sb₂O₃) oder Zirkonoxid (ZrO₂) mit einem Anteil von kleiner als 5 mol-% beigemischt wird.

2. Sputtertarget nach Anspruch 1, **dadurch gekennzeichnet, dass** der Anteil des Dotierstoffes im Bereich von 0,05 bis zu 1,0 mol-% liegt.

3. Sputtertarget nach Anspruch 1 oder 2, **dadurch gekennzeichnet, dass** als Dotierstoff Indiumoxid (In₂O₃) beigemischt wird.

4. Verwendung eines Sputtertargets nach Anspruch 1 zum Herstellen von Titandioxidschichten auf Substraten durch Gleichspannungs-Sputtertechnik.

5. Verfahren zur Herstellung eines Sputtertargets nach einem der Ansprüche 1 bis 3, **dadurch gekennzeichnet, dass** das Ausgangsmaterial aus Titandioxid mit dem Dotierstoff oder dem Dotierstoffgemischt vermischt, danach kaltgepresst und anschließend gesintert wird.

## Claims

1. An electrically conducting sputter target comprising titanium dioxide (TiO₂) having a specific electrical resistivity of less than 5 Ωcm, **characterised in that** at least one doping agent or a mixture of doping agents from the group of indium oxide (In₂O₃), zinc oxide (ZnO), bismuth oxide (Bi₂O₃), gallium oxide (Ga₂O₃), antimony oxide (Sb₂O₃) or zirconium oxide (ZrO₂) is added to the TiO₂ target material in an amount of less than 5 mole %.

2. The sputter target as claimed in Claim 1, **characterised in that** the doping agent is present in an amount of 0.05 to 1.0 mole %.

3. The sputter target as claimed in Claim 1 or 2, **characterised in that** indium oxide (In₂O₃) is added as doping agent.

4. Use of a sputter target as claimed in Claim 1 for producing titanium oxide layers on substrates by constant voltage sputter technique.

5. A method for producing a sputter target as claimed in any one of Claims 1 to 3, **characterised in that** the starting material comprising titanium dioxide is mixed with the doping agent mixture, then cold-pressed and finally sintered.

## Revendications

1. Cible de pulvérisation cathodique électriquement conductrice en dioxyde de titane (TiO₂) ayant une résistance électrique spécifique inférieure à 5 Ωcm, **caractérisée en ce qu'**au moins un dopant ou un mélange de dopants du groupe oxyde d'indium (In₂O₃), oxyde de zinc (ZnO), oxyde de bismuth (Bi₂O₃), oxyde de gallium (Ga₂O₃), oxyde d'antimoine (Sb₂O₃) ou oxyde de zirconium (ZrO₂) est ajouté au matériau de la cible en TiO₂ en une proportion inférieure à 5 mol%.

2. Cible de pulvérisation cathodique selon la revendication 1 **caractérisée en ce que** la proportion de dopant est située dans la plage de 0,05 à 1,0 mol%.

3. Cible de pulvérisation cathodique selon la revendication 1 ou 2 **caractérisée en ce que** de l'oxyde d'indium (In₂O₃) est ajouté comme dopant.

4. Utilisation d'une cible de pulvérisation cathodique selon la revendication 1 pour la production de couches de dioxyde de titane sur des substrats par la technique de pulvérisation cathodique en tension continue.

5. Procédé de production d'une cible de pulvérisation cathodique selon l'une des revendications 1 à 3 **caractérisé en ce que** le produit de départ en dioxyde de titane est mélangé avec le dopant ou le mélange de dopants, puis compressé à froid et ensuite fritté.
